Europäisches Patentamt

European Patent Office

Office européen des brevets

(11) Publication number: **0 104 051**
**B1**

## (12) EUROPEAN PATENT SPECIFICATION

(45) Date of publication of patent specification: **06.07.88**

(51) Int. Cl.⁴: **H 01 L 23/56,** H 01 L 23/04, H 01 L 23/48

(21) Application number: **83305397.8**

(22) Date of filing: **15.09.83**

(54) Noise protection for a packaged semiconductor device.

(30) Priority: **22.09.82 JP 165432/82**

(43) Date of publication of application:
**28.03.84 Bulletin 84/13**

(45) Publication of the grant of the patent:
**06.07.88 Bulletin 88/27**

(84) Designated Contracting States:
**DE FR GB**

(56) References cited:
**DE-A-2 047 458**
**GB-A-2 057 757**
**GB-A-2 091 035**
**US-A-4 283 839**

**PATENTS ABSTRACTS OF JAPAN, vol. 6, no. 215(E-138)(1093), 28th October 1982; & JP - A - 57 118 661 (FUJITSU K.K.) 23-07-1982**

(73) Proprietor: **FUJITSU LIMITED**
**1015, Kamikodanaka Nakahara-ku**
**Kawasaki-shi Kanagawa 211 (JP)**

(72) Inventor: **Wakabayashi, Tetsushi c/o Fujitsu Limited**
**Patent Department 1015 Kamikodanaka Nakahara-ku Kawasaki 211 (JP)**
Inventor: **Muratake, Kiyoshi c/o Fujitsu Limited Patent Department 1015 Kamikodana Nakahara-ku Kawasaki 211 (JP)**

(74) Representative: **Sunderland, James Harry et al HASELTINE LAKE & CO Hazlitt House 28 Southampton Buildings Chancery Lane London WC2A 1AT (GB)**

Courier Press, Leamington Spa, England.

## Description

The present invention relates to noise protection for a packaged semiconductor device.

As integration and packing densities of elements of integrated circuits (IC) increase, it becomes more and more important to protect the IC's from noise, to ensure reliable operation. Circuit design is more critical at higher integration densities and the allowable margins for the lower and higher levels of digital signals with respect to their threshold levels are reduced and thus malfunctions due to noise are more often suffered. In order to prevent noise problems a bypass capacitor is loaded between power source and ground.

Usually such a capacitor is mounted on a printed circuit board with terminals of the capacitor operationally connected to a power supply line and a ground line. The capacitor is intended mainly to protect an IC from noise induced on the power supply line. However, if the IC is highly integrated and operates at high speed, it is impossible to ignore distributed inductance between the capacitor and the IC. In addition, pulses generated by the IC itself may induce noise in the power source line which is not smoothed out by such a capacitor, and which may therefore be superposed on the source voltage and cause malfunctions.

Recently, attempts have been made to overcome these problems.

One attempt involves mounting a capacitor on the lid of an IC package and wiring one terminal of the capacitor to ground and another terminal of the capacitor to a power source pin of the IC package. However, inductance (between capacitor and IC) is not significantly reduced even though wire length is decreased (as compared with p.c.b. capacitor mounting) and noise problems are still experienced to an unsatisfactory degree.

Another attempt involves mounting a capacitor in an IC package. A chip capacitor is placed on an IC die bonding area of the package and the IC die is piled on the chip capacitor. However, this causes other problems. The worst is that the chip capacitor is placed in the same chamber as the IC die, which die requires an extremely clean environment. In addition, the heat generated by an IC in operation should be released from its package, but thermal resistance is increased when an IC die is piled on a chip capacitor. Another problem is that the package must be redesigned. The piling or stacking of IC die and chip capacitor requires additional height for the chamber in which they are mounted. This increases the cost of the IC package.

GB—A—2 091 035 discloses a packaged semiconductor device wherein a decoupling capacitor provides a mounting platform for an integrated circuit chip and is sealed with the chip in the IC package.

According to the present invention there is provided a packaged semiconductor device, comprising

an integrated circuit die,

a lead base for mounting thereon the die,

a lid bonded to the lead base, with a seal around the die,

a plurality of leads sandwiched between the lead base and the lid, and

a noise bypass capacitor, wherein the lid is such that it affords access to selected lead parts on the lead base, whilst an effective seal is maintained around the die, and the capacitor is mounted on the selected lead parts on the lead base.

An embodiment of the present invention can provide a semiconductor device which is protected from noise, thereby to allow stable operation.

An embodiment of the present invention can provide a semiconductor device in which noise protection is effected, with only a slight change in the device package, as compared with a standard package, thus avoiding increased package costs, and avoiding environmental and thermal problems.

An embodiment of the present invention can employ conventional IC dies and also conventional IC production processes without the need for any or any significant changes or redesigning.

In embodiments of the present invention, access to the selected lead parts may be provided by a hole in the lid or by a notch or cut-out at an edge or end of the lid.

Alternatively, a lid shorter than the lead base may be used to afford access to the selected lead parts.

The chip capacitor may be soldered to the selected lead parts, so that when it is in place no lead parts of the lead base are exposed (in effect to complete the lid).

In an embodiment of the present invention, access to selected lead parts is provided in a region used for connection between pins of the packaged device and the IC die which is not a seal margin region essential for effective sealing of the IC die. For example the notch or hole is made in a marginal region of the lid corresponding to an inessential part of the seal margin as present in previously proposed devices.

The chip capacitor is inserted into the notch or hole and one terminal thereof soldered to a power source lead and the other to a ground lead of the packaged device.

In embodiments of the present invention the leads are provided by a suitable lead frame. The chip capacitor may be soldered to the ground lead which forms a ground pin of the packaged semiconductor device, or to an additionally provided ground lead.

Reference is made, by way of example, to the accompanying drawings, in which:—

Figure 1 is a schematic perspective view illustrating in part an embodiment of the present invention;

Figure 2 is a schematic perspective view illustrating in part another embodiment of the present invention;

Figure 3 is a plan view illustrating a lead frame which is employed in an embodiment of the present invention;

Figure 4 shows the central part of the lead frame of Figure 3 to an enlarged scale; and

Figure 5 shows, to the same scale as Figure 4, the central part of another lead frame which is employed in another embodiment of the present invention.

As previously noted, in order to protect a high speed and highly integrated IC from noise, it is important to mount a noise bypass capacitor as close as possible to the IC die. However, the IC die requires an extremely clean environment and must be tightly sealed off to ensure this, so mounting the capacitor in the same place as the IC die should be avoided.

From the view point of sealing, especially for a dual-in-line package (usually called a dip type package), the sealing margin on both side of the longitudinal direction of the package is large compared to that on its lateral direction. So we can cut this part of the lid without any harm to the sealing of the IC die. As the integration becomes large and the IC die needs more connections to an outside printed circuit board, the number of pins increases. As the number of pins increases the length of the package increases. This means that highly integrated ICs have ample margin which can be cut into.

That is, considering the sealing off of an IC die in its package, for example a dual in line package, a sealing margin extends around the IC die. In a dual in line package the size of the sealing margin at the opposite longitudinal ends of the package is relatively large as compared with the size of the sealing margin along the two sides of the package. The inventors have determined that the size of the sealing margin at the opposite longitudinal ends is larger than is necessary to maintain an effective seal, and that an effective seal can still be provided with a part of the IC package lid removed or omitted at a longitudinal end of the package.

Moreover, as the scale of integration increases and the IC die needs more connections to an external printed circuit board, the number of pins required on a package increases and consequently the dimensions (e.g. length) of a package increases. Thus packages for highly integrated IC's afford margins of sufficient size to permit such removal or omission with no detrimental effects on sealing.

In embodiments of the present invention the above-mentioned margins are utilized to provide chip (noise bypass) capacitor mounting spaces. A hole or cut-out, for example, is provided in a package lid in a region corresponding to such a margin, to give access to selected lead parts, and a chip capacitor is, for instance, soldered directly to the selected lead parts so exposed.

Dual in line packages are generally called dip-10, dip-16, dip-20, etc., packages according to the number of pins carried.

Embodiments of the present invention described below are concerned with dip-16 type packages and in particular glass sealed ceramic type dip-16 packages (so called 'cerdip'). However it will be understood that the present invention can be applied to other types of packages, for example dip packages of different pin numbers and non-dip packages such as flat pack type packages. The present invention can be applied to any package type in which leads are sandwiched between a lead base and lid.

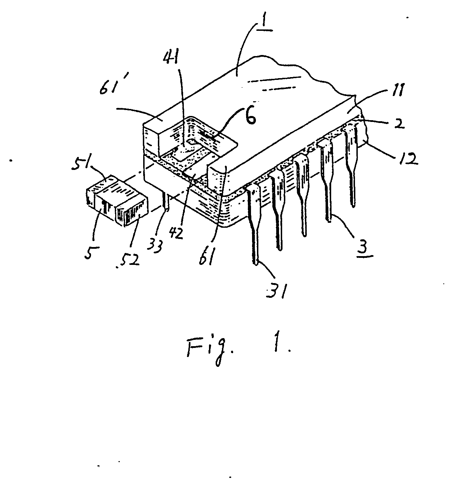

Figure 1 illustrates a packaged semiconductor device embodying the present invention. In Figure 1, 1 is a dip type ceramic IC package (a so-called cerdip type package). 11 is a lid of the package, 12 is a lead base of the package, and these are bonded together by a glass layer 2. Leads are sandwiched between the lid 11 and the lead base 12. When the package is mounted on a printed circuit board, pins 3 of the dip are connected to the printed circuit board for operationally connecting the IC die and external circuitry.

As seen in Figure 1, a generally rectangular cut 6 is made in an end of the lid 11 to provide a notch or cut-out in the lid. The cut is confined to the sealing margin around the IC die, so that a seal can be maintained even in the absence of part of the lid. In the absence of part of the lid 11 parts of some of the leads which are sandwiched between the lid 11 and the lead base 12 are thus exposed as shown at 41 and 42.

The cut 6 is designed to fit the shape of a chip or noise bypass capacitor 5 and when in place the capacitor is soldered to 41 and 42 (i.e. capacitor terminals 51 and 52 are soldered to 41 and 42).

The chip capacitor 5 is preferably small in size with a capacitance as large as possible. For example, the chip capacitor may be a barium titanate capacitor. One example of a chip capacitor for an embodiment of the present invention has a capacitance in the range 0.1 to 5 micro-farads, a length of 2 mm, a width of 1 mm and a height of 0.5 mm.

It will thus be understood that the notch or cut-out defined by cut 6 in Figure 1 may be very small. For example a rectangular space 3 mm wide and 3 mm long is sufficient to mount a chip capacitor. This should be compared with the width of the lid 11 (approximately 7 mm) of the dip type package shown in Figure 1.

A sealing margin width of 1.5 or 2 mm is sufficient to secure IC die sealing, and the cut 6 reduces the size of the sealing margin available only to a small extent. There is sufficient sealing margin space left for IC die sealing to be unaffected.

As an alternative to provision of a notch or cut-out as shown in Figure 1, it is possible simply to use a lid of reduced (e.g. cut down) length.

However, a reduced-length lid does not afford side walls 61 and 61' which can be seen in Figure 1. Because ICs are usually mounted on printed circuit boards by automatic machine, IC lead pins have to withstand fairly large forces when they are inserted into printed circuit board holes. According to the experience of the inventors of the present invention, packages in which the side walls 61 and 61' are absent can suffer trouble with loose pins. Packages with side walls 61 and 61' as shown in Figure 1 afford sufficient pin strength to avoid trouble with loose pins.

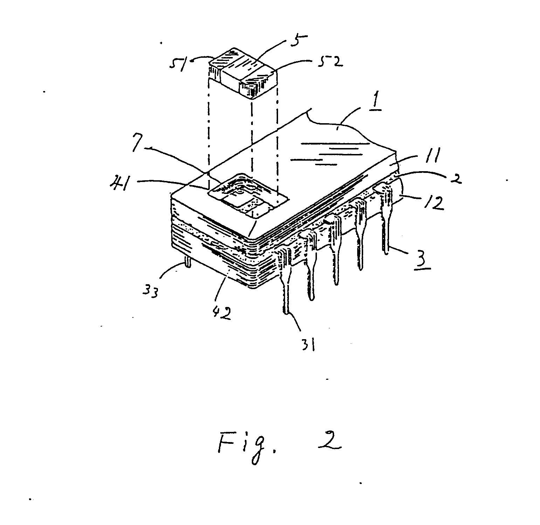

Figure 2 illustrates another embodiment of the present invention, in which the lid 11 of the package 1 is provided with a generally rectangular hole 7. The hole 7 is located on the sealing margin around the IC die as is the cut 6 described with regard to Figure 1. The size of the hole 7 is comparable to that of the notch or cut-out in Figure 1; that is, for example, the hole 7 is 3 mm long and 3 mm wide.

Through the hole 7, lead parts·are exposed as shown at 41 and 42 in Figure 2. A chip capacitor 5 is inserted into this hole and capacitor terminals 51 and 52 soldered to the exposed lead parts.

It is easy to cut a lid, or to provide a hole in the lid as described above with reference to Figures 1 and 2.

Of course, a lid may be pre-formed with a notch, cut-out or hole as shown in Figure 1 or 2, before the lid is baked and sintered in an oven. No essential change in the manufacturing process of the lid is involved.

The pins of an IC package are usually designated by numbers. Usually a pin close to a specific mark on the lid is designated as pin No. 1. In the embodiments of the present invention described with reference to Figures 1 and 2 the most noticeable mark on the lid is the cut 6 or hole 7. Hence, with reference to Figures 1 and 2 let the pin labelled 31 be pin No. 1 and the remaining pins be numbered sequentially in a counterclockwise sense in those Figures. Then, with regard to the dip-16 type package of Figures 1 and 2, the pin at the opposite end of the package on the same side as pin No. 1 is pin No. 8, the pin opposite pin No. 8 is pin No. 9, and the pin opposite pin No. 1 is pin No. 16.

In many dip-16 packages pin No. 16 is the power source pin and pin No. 8 is the ground pin. Thus, source and ground pins are at diagonally opposite corners of the package.

As mentioned above the chip capacitor should be mounted as close as possible to the IC die and its power source pin. This means that one terminal of the capacitor should be connected to a power source lead part. Of course, the other terminal of the capacitor is to be connected to ground. However, if pin No. 8 is the ground pin, the lead to that ground pin is remote from the power source lead and is not exposed by a cut-out or hole in the lid as shown in Figures 1 and 2.

Thus, if such conventional pin utilisation is to be maintained, an additional ground lead, exposed by the cut-out or hole in the lid must be provided.

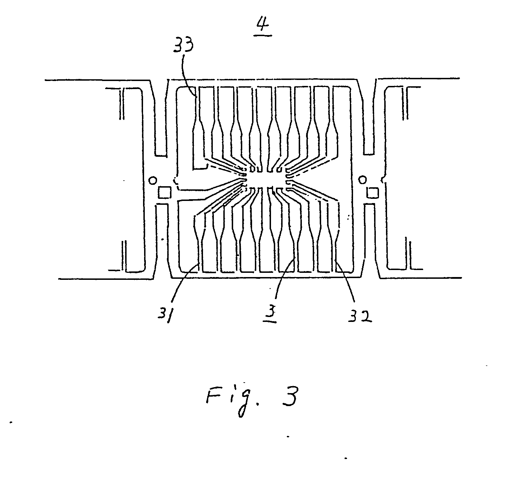

Figure 3 illustrates a lead frame 4 employed in the embodiments of Figs. 1 and 2 when conventional pin utilisation is maintained.

Usually, a lead frame pattern is symmetrical with respect to a frame centre line. However, it will be seen that the left side of the lead frame pattern of Figure 3 differs from that of the right side. On the left side an additional ground lead is provided which will be exposed by the lid cut-out or hole of Figures 1 and 2. Nevertheless, both sides of the lead pattern provide an arrangement of spokes for connecting pins to the IC die.

Usually, lead frames are made in a long chain, each frame having the same lead pattern (the pattern of only one frame is shown in Figure 3). The longitudinal direction of the lead frame (chain) corresponds to the longitudinal direction of the package into which the frame will be glazed. Generally, the lead frames are formed from metal ribbon by punching or etching, so it is easy to modify the usual symmetrical pattern to the pattern of Figure 3. This involves simply altering the punch or etching pattern, on its left side.

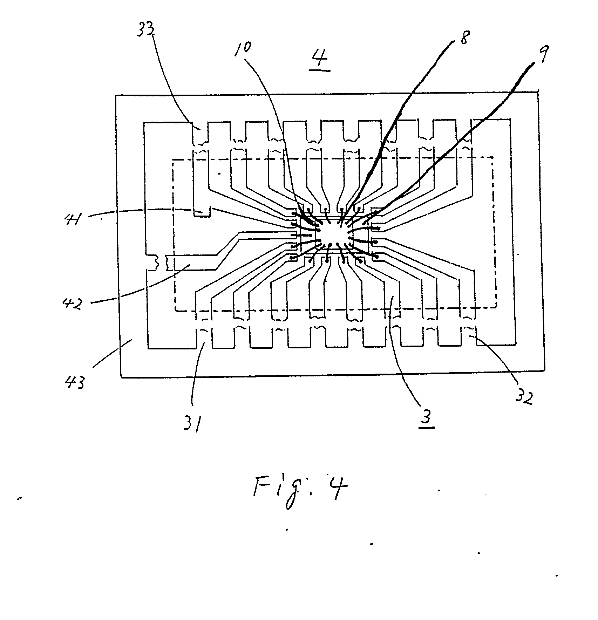

Figure 4 shows a central part of the lead frame pattern of Figure 3 to an enlarged scale. It will be seen clearly that an additional spoke, or post, 42 is added to the lead frame 4.

Further, the spoke providing pin No. 16 (the power source pin for IC die 8 on base 9) is provided with a bulge or extension 41.

Moreover the spoke of pin No. 1 is so angled (bent) as to provide space for the post 42.

It will be appreciated that lead parts 41 and 42 are the parts exposed in Figures 1 and 2.

As can be seen in Figure 4, an IC die 8 (which may be of any type, for example a memory circuit) is mounted on a metallized base 9 usually by eutectic bonding or glazing, according to whether it is necessary to ground or float the back surface of the die from the base 9. The IC die 8 is connected to the leads by gold or aluminium wire 10 by a conventional wire bonding technique. A ground lead 32 (pin 8) is connected to the base 9. The base 9 is connected to the additional spoke or post 42 by wire bonding. To facilitate this bonding, the additional post 42 is extended towards the base. The spoke with bulge 41 connects to pin No. 16, which is the power source pin, and the post 42 is connected to the base, hence to ground. Thus, with a lead frame as shown in Figures 3 and 4, the chip capacitor 5 of Figures 1 and 2 is mounted between power source and ground at a point adjacent the IC die.

As an alternative to the utilisation of pin No. 16 as power source pin and pin No. 8 as ground pin, some dip-16 packages use pin No. 1 as power source pin and pin No. 9 as ground pin.

It will be understood that this case is essentially similar to the pin No. 16—pin No. 8 arrangement—the power source and ground pins are still diagonally opposite—and that a lead frame as shown in Figures 3 and 4 and a lid as shown in Figure 1 or 2 can be used turned over or reversed to achieve the same result.

In Figure 4, a chain line illustrates the edge of the lid and the lead base when they are glazed with the leads 3 sandwiched between them in a completed package. Preferably, the additional spoke, or post, 42 should have no external pin part, because standard dip type cases provide for no additional pins. Thus, the additional spoke is cut off from an outer lead frame part 43 after the leads 3 have been sandwiched between lid and lead base. It is also desirable that the additional post has no tail part outside the package, because a tail could be (scratched) caught, causing damage to the package or causing leakage.

It is difficult to cut the frame without leaving an external tail on the additional spoke. To overcome this problem the additional spoke 42 in Figure 4 is provided with a half cut groove (for example when the frame is punched out) at the edge of the package (at the place where the chained line crosses the spoke 42 in Figure 4). After the lead frame is glazed to the lead base and the lid, it is then easy to break off the outer frame without leaving a tail on the additional spoke, merely by bending at the half cut groove. This is accomplished automatically in the process of bending the external pins 3.

In relation to Figures 3 and 4 an embodiment of the present invention is described which is adapted to conventional devices already in production and in wide use, to improve their operations in a noisy environment. In such a device, the arrangement of bonding areas to be wire bonded to corresponding leads is thus already fixed, and the arrangement of the pins of the package to be connected to an external printed circuit board is also fixed. However, without these restrictions, the situation is quite different, as IC die bonding areas or package pin connections can be rearranged.

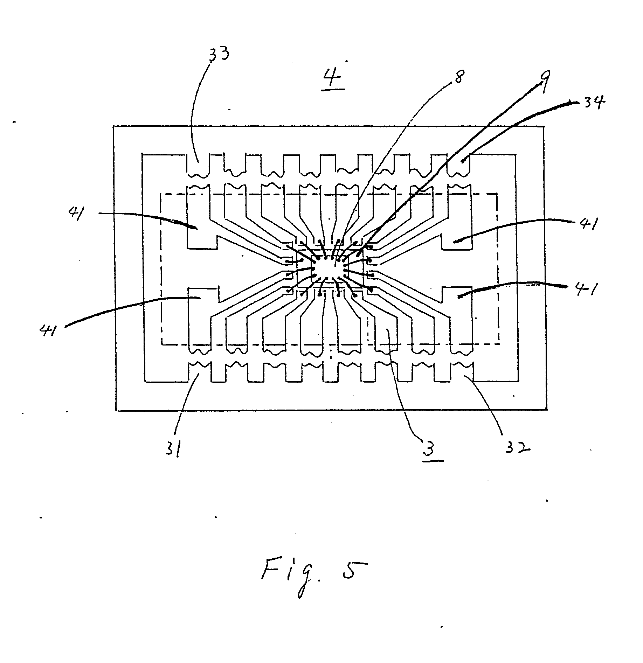

An example of lead frame for use in an embodiment of the present invention in which such restrictions are not observed is shown in Figure 5. Figure 5 shows a center part of the lead frame in a manner corresponding to Figure 4. As can be seen in Figure 5, the lead frame 4 is designed with symmetrical left and right sides. Bulges 41 to which the chip capacitor is soldered in a packaged device, are provided on each of leads 31, 32, 33 and 34 (which correspond to pins No. 1, 8, 16 and 9 of a dip-16 type package). In this case an additional spoke or post as in Figures 3 and 4 is unnecessary. The chip capacitor may be loaded in correspondence to either end of the lead frame, as required by the circuit design. However, if pin No. 1 is chosen as a power source pin, pin No. 16 should be the ground pin and vice versa. The pins No. 8 and 9 can be used. in the same way.

Of course symmetry of the lead frame is not always necessary, and bulges 41 may be made on only one side of the lead frame. However, the example shown in Figure 5 is better than others, because it can be applied to a wider variety of circuit design and applications.

Now, explanation will be given of the soldering of the chip capacitor in place.

Before soldering of the capacitor, the IC die is mounted and wire bonded as in an ordinary IC manufacturing process. The lid, for example, having a rectangular cut or rectangular hole as described above, is glazed to the lead base and the lead frame to seal off the IC die.

This requires no change to the ordinary IC manufacturing process.

The surfaces of the leads exposed by the lid are oxidised to some extent in the above-mentioned processes. It is desirable to remove the oxide layer on the surface of parts 41 and 42 in Figures 1 and 2 by etching, and to solder them beforehand (i.e. apply solder to the parts 41 and 42 in advance). The terminals 51 and 52 of the chip capacitor shown in Figures 1 and 2 are also soldered in advance. Then the chip capacitor 5 is placed with its terminals 51 and 52 facing the pre-soldered lead parts 41 and 42 respectively. The complete package is then heated in an oven. The melting point of the solder is much lower than those of the die bonding material, wire bonding material and glazing, so the soldering process does not harm the IC circuit. Because the IC die is sealed off effectively, flux or other contaminants adhering after the soldering process can be washed out, after the process is finished.

The cut or hole in the lid, it should be understood, is not limited to a rectangular shape. For example a U-cut may be used. However, a rectangular shape may be the most natural and preferable.

The use of rectangular cuts and the use of rectangular holes in the lid have merits and demerits.

The inventors of the present invention believe that the former is preferable to the latter with regard to the washing process effected after soldering-in of the chip capacitor. However, the latter has an appearance closer to normal dip type packages.

As will be understood the present invention requires no basic changes in ordinary IC manufacturing processes. It can be applied in a mass production system. It can be applied to any type of IC to improve its stability in a noisy environment, without redesign of the IC die or external circuitry.

Although the illustrated embodiments concern dip-16 type packages, embodiments of the present invention can be applied to any type of dual in line type ceramic packaged electronic devices, and to any semi-conductor device sealed in a ceramic package with leads sandwiched between a lid and a lead base.

The cut portion may be located at one end of said lid.

The cut portion may be located in the portion closest to a power source pin of said semiconductor device.

The leads may comprise an additional post for connecting said chip capacitor, said additional post not being projected out from an edge of said lead base.

The cut portion may be a rectangular cut.

The cut portion may be a rectangular hole.

The additional post may be formed on a lead frame, with a half cut groove made on a position where said additional post crosses an edge of said lead base.

## Claims

1. A packaged semiconductor device, comprising
an integrated circuit die (8),
a lead base (12) for mounting thereon the die (8),
a lid (11) bonded to the lead base, with a seal around the die,
a plurality of leads (3) sandwiched between the lead base and the lid, and
a noise bypass capacitor (5),
wherein the lid (11) is such that it affords access to selected lead parts (41, 42) on the lead base (12), whilst an effective seal is maintained around the die (8), and the capacitor (5) is mounted on the selected lead parts on the lead base.

2. A device as claimed in claim 1, wherein such access is afforded by a hole (7) in the lid (11).

3. A device as claimed in claim 1, wherein such access is afforded by a cut-out portion (6) at one end of the lid (11).

4. A device as claimed in claim 2 or 3, wherein the hole (7) or the cut-out portion (6), as the case may be, is rectangular in shape.

5. A device as claimed in claim 1, wherein such access is afforded by virtue of the lid (11) being shorter than the lead base (12).

6. A device as claimed in any preceding claim, wherein the selected lead parts (41, 42) are a part of a power source pin lead (41) and a part of an additional lead (42) which does not extend beyond the edge of the lead base.

7. A device as claimed in claim 6, wherein the additional lead (42) is connected to a metallized base (9) which is connected to the ground pin lead.

8. A device as claimed in any one of claims 1 to 5, wherein the selected lead parts (41, 42) are a part of a power source pin lead and a part of a ground pin lead.

9. A device as claimed in claim 6 or 7, wherein the said plurality of leads (3) are provided by respective spokes of a lead frame (4) having an additional spoke (42), corresponding to the additional lead, weakened or partially cut at a location corresponding to the edge of the lead base (12).

## Patentansprüche

1. Verpackte Halbleitervorrichtung mit
einem integrierten Schaltungsscheibchen (8),
einer Leitungsbasis (12), um darauf das Scheibchen (8) zu montieren,
einem Deckel (11), der auf der Leitungsbasis aufgeklebt ist, mit einer Dichtung um das Scheibchen;
einer Vielzahl von Leitungen (3), die schichtartig zwischen Leitungsbasis und Deckel angeordnet sind, und

einem Rausch-Bypass-Kondensator (5),
bei welcher der Deckel (11) derart ist, daß er einen Zugang zu ausgewählten Leitungsabschnitten (41, 42) auf der Leitungsbasis (12) erlaubt, während eine effektive Dichtung um das Scheibchen (8) aufrechterhalten wird, und der Kondensator (5) auf ausgewählten Leitungsabschnitten der Leitungsbasis montiert ist.

2. Vorrichtung nach Anspruch 1, bei der solch ein Zugriff durch ein Loch (7) in dem Deckel (11) ermöglicht ist.

3. Vorrichtung nach Anspruch 1, bei der solch ein Zugriff durch einen ausgeschnittenen Teil (6) an einem Ende des Deckels (11) ermöglicht ist.

4. Vorrichtung nach Anspruch 2 oder 3, bei der ein Loch (7) oder ein ausgeschnittener Abschnitt (6), was immer der Fall sein mag, eine rechteckige Form hat.

5. Vorrichtung nach Anspruch 1, bei der solch ein Zugriff aufgrund eines Deckels (11), der kurzer als die Leitungsbasis (12) ist, ermöglicht ist.

6. Vorrichtung nach einem der vorhergehenden Ansprüche, bei der ausgewählte Leitungsabschnitte (41, 42) Teil einer Energiequellen-Stiftleitung (41) und Teil einer zusätzlichen Leitung (42) sind, welche sich nicht über den Rand der Leitungsbasis hinaus erstreckt.

7. Vorrichtung nach Anspruch 6, bei der die zusätzliche Leitung (42) mit einer metallisierten Basis (9) verbunden ist, welche mit dem Erdleitungsstift verbunden ist.

8. Vorrichtung nach einem der Ansprüche 1 bis 5, bei der die ausgewählten Leitungsabschnitte (41, 42) Teil eines Energiquellen-Leitungsstiftes und Teil eines Erdleitungsstiftes sind.

9. Vorrichtung nach Anspruch 6 oder 7, bei der die genannte Vielzahl von Leitungen (3) durch entsprechende Sprossen eines Leitungsrahmens (4) vorgesehen sind, welcher eine zusätzliche Sprosse (42) hat, die der zusätzlichen Leitung entspricht, geschwächt oder teilweise geschnitten an einem Ort, welcher dem Rand der Leitungsbasis (12) entspricht.

## Revendications

1. Composant à semi-conducteur sous boîtier, comportant
une pastille de circuits intégrés (8),
une base de connexion (12) sur laquelle doit être montée la pastille (8),
un couvercle (11) fixé sur ladite base de connexion avec un joint autour de la pastille,
plusieurs conducteurs (3) intercalés entre la base de connexion et le couvercle, et
un condensateur (5) de dérivation de parasites,
dont le couvercle (11) est tel qu'il donne accès à des parties conductrices sélectionnées (41, 42) sur la base de connexion (12) pendant qu'un joint effectif est maintenu autour de la pastille (8) et le condensateur (5) étant monté sur les parties conductrices sélectionnées de la base conductrice.

2. Composant selon la revendication 1, dans lequel l'accès est donné par un trou (7) dans le couvercle (11).

3. Dispositif selon la revendication 1, dans lequel l'accès est donné par une partie découpée (6) à une extrémité du couvercle (11).

4. Composant selon la revendication 2 ou 3, dans lequel le trou (7) ou la partie découpée (6), suivant le cas, a une forme rectangulaire.

5. Composant selon la revendication 1, dans lequel l'accès est donné par le fait que le couvercle (11) est plus court que la base de connexion (12).

6. Composant selon l'une quelconque des revendications précédentes, dans lequel les parties conductrices sélectionnées (41, 42) font partie d'un conducteur de broche d'alimentation (41) et d'une partie d'un conducteur supplémentaire (42) qui ne se prolonge pas au delà du bord de la base de connexion.

7. Composant selon la revendication 6, dans lequel le conducteur supplémentaire (42) est connecté à une base métallisée (9) qui est connectée au conducteur de broche de masse.

8. Composant selon l'une quelconque des revendications 1 à 5, dans lequel les parties conductrices sélectionnées (41, 42) font partie d'un conducteur de broche d'alimentation et d'un conducteur de broche de masse.

9. Composant selon la revendication 6 ou 7, dans lequel lesdits plusieurs conducteurs (3) sont constitués par des branches respectives d'un cadre de connexion (4) comprenant une branche supplémentaire (42) correspondant au conducteur supplémentaire, affaiblie ou coupée partiellement dans une position correspondant au bord de la base de connexion (12).

Fig. 1.

Fig. 2

Fig. 3

Fig. 4

Fig. 5